# EUROPÄISCHE PATENTSCHRIFT

(11) **EP 2 993 736 B1**
(45) Veröffentlichungstag und Bekanntmachung des Hinweises auf die Patenterteilung: **16.11.2016**
(21) Anmeldenummer: 14003043.8
(22) Anmeldetag: 03.09.2014
(51) Int. Cl.: H01R 9/03, H01R 12/53, H01R 12/58, H05K 3/32, H05K 3/34

(54) **Elektronische Baueinheit**
Electronic component
Composant électronique

(43) Veröffentlichungstag der Anmeldung: 09.03.2016
(73) Patentinhaber: MD Elektronik GmbH, 84478 Waldkraiburg (DE)
(72) Erfinder: Halbig, Thomas, 84405 Dorfen (DE)
(74) Vertreter: Hofmann, Ernst

(56) Entgegenhaltungen:
- WO-A1-2013/132283
- FR-A1- 2 923 672
- US-A1- 2006 234 556
- US-A1- 2009 301 761
- US-A1- 2012 149 238

## Beschreibung

Die Erfindung betrifft eine elektronische Baueinheit umfassend eine Leiterplatte und ein Kabel, insbesondere ein Rundkabel, die insbesondere zur Übertragung von Signalen in Fahrzeugen geeignet ist, gemäß dem Anspruch 1.

Die betreffenden Baueinheiten sind etwa in Kraftfahrzeugen oder Luftfahrzeugen einsetzbar und werden meist in großen Stückzahlen benötigt. Zur kostengünstigen Bereitstellung entsprechender Baueinheiten sind ein einfacher Aufbau und eine einfache Konfektionierbarkeit beziehungsweise Montierbarkeit von großer Bedeutung.

### STAND DER TECHNIK

In der US 5 806 179 ist ein Rundkabel gezeigt, dessen Adern mit Hilfe eines flachen Plastikkörpers zur Vereinfachung der Montage mit einer Leiterplatte nach einem vorgegeben Muster linear aneinandergereiht sind.

In der Offenlegungsschrift WO 2013/123283 A1 wird eine Sensoreinheit beschrieben, die einen Stecker insbesondere zur Ausgabe von Sensorsignalen aufweist. Zum Zweck einer leichten Montierbarkeit wird dort eine spezielle Ausgestaltung des Steckers vorgeschlagen, so dass auf einen Lötprozess zur elektrischen Kontaktierung verzichtet werden kann.

Aus der Offenlegungsschrift US 2006/0234556 A1 ist eine elektronische Baueinheit bekannt, die eine Leiterplatte mit mehreren Bohrungen aufweist und ein mehradriges Kabel mit entsprechend mehreren Leitern. Ferner weist jene Baueinheit eine Stützschelle auf mit einem radial außerhalb der Adern angeordneten Befestigungselement. Die Baueinheit weist weiterhin einen Körper auf. Die Enden der Adern sind gemäß der US 2006/0234556 A1 nach einem vorgegebenen Muster positioniert und mit der Leiterplatte elektrisch kontaktiert.

US2009/301761 A1 wird als nächstliegender Stand der Technik gegenüber dem Gegenstand des Anspruchs 1 angesehen. Es offenbart eine elektronische Baueinheit umfassend eine Leiterplatte und ein Kabel, wobei die Leiterplatte mindestens drei erste Bohrungen aufweist, die nach einem vorgegebenen Muster in der Leiterplatte angeordnet sind, das Kabel mindestens drei Adern aufweist, die um eine Längsachse des Endes des Kabels herum angeordnet sind und jeweils einen Leiter umfassen, wobei das Kabel ferner eine Stützschelle aufweist, die ein radial außerhalb der Adern angeordnetes Befestigungselement aufweist, und - einen Körper aufweist, wobei der Körper erste Ausnehmungen aufweist, wobei die Enden der Adern nach einem vorgebebenen Muster positioniert sind, und wobei die Leiter mit der Leiterplatte elektrisch kontaktiert sind.

### ZUSAMMENFASSUNG DER ERFINDUNG

Der Erfindung liegt die Aufgabe zugrunde, eine elektronische Baueinheit zu schaffen, die insbesondere zur Übertragung von Signalen beziehungsweise Daten geeignet ist und mit vergleichsweise geringem Herstellungsaufwand fertigbar ist.

Diese Aufgabe wird erfindungsgemäß durch die Merkmale des Anspruchs 1 gelöst.

Erfindungsgemäß umfasst die elektronische Baueinheit eine Leiterplatte und ein Kabel, wobei die Leiterplatte mindestens drei erste Bohrungen aufweist, die nach einem vorgegebenen Muster in der Leiterplatte angeordnet sind. Das Kabel weist seinerseits mindestens drei Adern auf, die um eine Längsachse des Endes des Kabels herum angeordnet sind und jeweils eine Isolierung und einen Leiter umfassen. Weiterhin weist das Kabel eine Stützschelle auf, die ihrerseits ein radial außerhalb der Adern angeordnetes Befestigungselement aufweist. Die Adern sind durch das Befestigungselement in radialer Richtung zusammengepresst und derart gehalten, dass die Stützschelle relativ zu den Adern verdrehfest fixiert ist. Zudem weist das Kabel einen so genannten Körper auf, wobei der Körper erste Ausnehmungen aufweist und die Adern in den ersten Ausnehmungen angeordnet sind und eine zweite Ausnehmung aufweist, in welcher die Stützschelle verdrehfest aufgenommen ist. Das Kabel ist so ausgestaltet, dass die Stützschelle ihrerseits auch mit dem Körper bezüglich der Längsachse verdrehfest verbunden ist und durch den Körper der Verlauf der Adern so umgelenkt ist, dass die Enden der Adern nach dem vorgebebenen Muster positioniert sind wobei an den Enden der Adern die Isolierungen entfernt sind, so dass die Leiter in diesen Bereichen freigelegt sind Die Leiter sind in den ersten Bohrungen platziert und mit der Leiterplatte elektrisch kontaktiert. Insbesondere sind die Leiter in den ersten Bohrungen so platziert, dass eine Durchkontaktierung vorliegt, also die Leiter durch die erste Bohrungen hindurch gesteckt werden.

Das Kabel weist also mehrere Adern auf, die um eine Längsachse des Endes des Kabels herum angeordnet sind, so dass das Kabel auch insbesondere als Rundkabel bezeichnet werden kann, in dem die Adern kreisförmig gebündelt in einem runden Mantel, der als Isolierschlauch ausgebildet sein kann, angeordnet sein können (im Gegensatz zu einem Flachbandkabel, bei dem die Adern linear nebeneinander angeordnet sind).

Das vorgebebene Muster, nach dem die Enden der Adern positioniert sind, weicht von einem linearen Muster ab. Die Enden der Adern spannen also eine geometrische Fläche auf und sind nicht entlang einer Line angeordnet. Der Begriff Längsachse bezieht sich insbesondere auf das Ende des Kabels oder auf das Kabel in gestreckter Form.

Es ist gerade im Hinblick auf eine einfache und gegebenenfalls automatisierbare Montage von Vorteil, dass durch die beschriebene Anordnung die Adern durch ein einziges Befestigungselement verdrehfest fixiert sind. Wenn bei der Montage der Stützschelle auf die korrekte winkelmäßige Orientierung in Bezug auf die Adern geachtet wird, kann auf eine einfache Weise ein korrektes Zusammenfügen der Leiter mit der Leiterplatte erreicht werden.

Mit Vorteil ist Längsachse des Endes des Kabels orthogonal beziehungsweise senkrecht zur Leiterplatte orientiert.

In einer bevorzugten Variante weist das Kabel vier Adern, die miteinander verdrillt sind, auf. Zudem kann das Kabel auch einen Schirm, der beispielsweise ein Schirmgeflecht umfasst, aufweisen. Insbesondere kann das Kabel nach einem Stern-Vierer-Konzept aufgebaut sein.

Erfindungsgemäß weist der Körper erste Ausnehmungen auf, wobei die Adern in den ersten Ausnehmungen angeordnet sind. Die ersten Ausnehmungen sind vorzugsweise parallel zur Längsachse orientiert, beziehungsweise verlaufen parallel zur Längsachse. Die ersten Ausnehmungen können so ausgestaltet sein, dass die Adern formschlüssig, beispielsweise durch eine Hinterschneidung, in radialer Richtung gehalten werden (mit einer Haltekraft orthogonal zur Längsachse).

Erfindungsgemäß weist der Körper eine zweite Ausnehmung auf, in welcher die Stützschelle, insbesondere formschlüssig, verdrehfest aufgenommen ist. Das Kabel ist also so ausgestaltet, dass die Adern relativ zur Stützschelle winkelrichtig angeordnet sind und zudem bedingt durch das Zusammenwirken der zweiten Ausnehmung des Körpers mit der Stützschelle eine winkelrichtige Orientierung zwischen den Adern und der Stützschelle gegeben ist.

In vorteilhafter Weise kann der Körper von einer radial außen liegenden Hülse umgeben sein. Dabei kann der Körper mit der Hülse mechanisch verbunden sein, etwa durch eine Verrastung.

Weiterhin kann die Hülse verdrehfest mit der Stützschelle verbunden sein.

Gemäß einer vorteilhaften Ausgestaltung der Erfindung weist die Stützschelle ein als Gabel ausgestaltetes Ende auf und die Hülse zumindest einen Schlitz wobei die Gabel, beziehungsweise ein Zinken der Gabel, in den zumindest einen Schlitz eingreift. Vorzugsweise weist die Hülse zumindest zwei Schlitze auf, wobei dann die Gabel, in die zumindest zwei Schlitze eingreift, beziehungsweise Zinken der Gabel in die zumindest zwei Schlitze eingreifen.

Mit Vorteil ist die elektronische Baueinheit so ausgestaltet, dass die Adern von der Hülse, die in Bezug auf die Adern radial außen liegt, umgeben sind.

Weiterhin kann auch die Stützschelle mit der Leiterplatte verbunden sein, beispielsweise durch eine Lötverbindung oder durch eine Klebeverbindung.

In vorteilhafter Ausgestaltung der Erfindung weist die Stützschelle ein als Gabel ausgestaltetes Ende auf, welches in zumindest einer zweiten Bohrung der Leiterplatte platziert ist. Demgemäß kann die Gabel mit der Leiterplatte verbunden sein, beispielsweise durch eine Lötverbindung, eine Verrastung oder durch eine Klebeverbindung. Im Falle einer Verrastung kann die Gabel einen Rasthaken aufweisen, der mit der zweiten Bohrung der Leiterplatte so zusammenwirkt, dass die Gabel beziehungsweise die Stützschelle nach erfolgter Montage mit der Leiterplatte mechanisch verbunden ist.

Weder die ersten Bohrungen noch die zweite Bohrung müssen zwangsläufig durch einen Bohrprozess hergestellt sein. Im Folgenden ist unter dem Begriff Bohrung eine Vertiefung oder ein Durchbruch zu verstehen, wobei eine derartige Bohrung mit rundem Querschnitt aber auch eckig oder unrund ausgestaltet sein kann.

Gemäß einer bevorzugten Variante ist je einer der Leiter in je einer der ersten Bohrungen platziert, wobei die Leiterplatte zumindest eine zweite Bohrung aufweist, in der ein Ende der Stützschelle platziert ist. Dabei liegt die zumindest eine zweite Bohrung außerhalb derjenigen Fläche, welche durch die Mittelpunkte der ersten Bohrungen aufgespannt ist.

Die Leiterplatte weist mindestens drei erste Bohrungen auf, die nach dem vorgegebenen Muster in der Leiterplatte angeordnet sind. Das vorgegebene Muster weicht von einem linearen Muster ab. Die ersten Bohrungen (beziehungsweise deren Mittelpunkte) spannen also eine geometrische Fläche auf und sind nicht entlang einer Line angeordnet.

In weiterer Ausgestaltung der Erfindung weist die Leiterplatte vier erste Bohrungen auf, die nach dem vorgegebenen Muster in der Leiterplatte angeordnet sind. Das vorgegebene Muster ist so ausgestaltet, dass die vier ersten Bohrungen auf den Ecken eines (gedachten) Quadrats liegen.

Mit Vorteil weist die Leiterplatte zwei zweite Bohrungen auf, die außerhalb des Quadrats liegen und in denen ein Ende der Stützschelle platziert ist. Das Ende kann als Gabel ausgestaltet sein, so dass die Gabel in den zwei zweiten Bohrungen platziert ist, beziehungsweise zwei Zinken der Gabel in den zwei zweiten Bohrungen platziert sind.

Erfindungsgemäß sind die Adern durch das Befestigungselement der Stützschelle in radialer Richtung zusammengepresst. Insbesondere kann das Befestigungselement als Crimphülse ausgestaltet sein, so dass nach dem Crimpen die Adern in radialer Richtung, also zur Längsachse hin, zusammengepresst sind. Das Befestigungselement beziehungsweise die Crimphülse kann dabei an einem Mantel des Kabels oder an einem Schirm des Kabels fixiert sein. Das Befestigungselement kann den Mantel des Kabels beziehungsweise den Schirm unter direkten unmittelbaren Kontakt umschließen. Vorteilhafte Ausbildungen der Erfindung entnimmt man den abhängigen Ansprüchen.

Weitere Einzelheiten und Vorteile des erfindungsgemäßen Kabels ergeben sich aus der nachfolgenden Beschreibung zweier Ausführungsbeispiele anhand der beiliegenden Figuren.

### KURZE BESCHREIBUNG DER ZEICHNUNGEN

Es zeigen die
- Figur 1: eine perspektivische Ansicht einer Leiterplatte vor dem Zusammenfügen mit einem Kabel,
- Figur 2: eine perspektivische Ansicht des Kabels vor dem Konfektionieren,
- Figur 3: eine Vorderansicht des Kabels,
- Figur 4: eine perspektivische Ansicht einer Stützschelle,
- Figur 5: eine perspektivische Ansicht des Kabels mit der Stützschelle,
- Figur 6: eine perspektivische Ansicht des Kabels mit der Stützschelle und mit aufgespreizten Adern,
- Figur 7: eine perspektivische Ansicht eines Körpers zur Umlenkung der Adern,
- Figur 8: eine perspektivische Ansicht des Kabels mit dem Körper zur Umlenkung der Adern nach einem weiteren Konfektionierungsschritt,
- Figur 9: eine perspektivische Ansicht des Kabels mit dem Körper zur Umlenkung der Adern, die sich in Ausnehmungen befinden,
- Figur 10: eine weitere perspektivische Ansicht des Kabels mit dem Körper zur Umlenkung der Adern nach dem Konfektionierungsschritt gemäß der Figur 8,
- Figur 11: eine perspektivische Ansicht einer Hülse,
- Figur 12: eine perspektivische Ansicht des Kabels mit der Hülse nach einem weiteren Konfektionierungsschritt,
- Figur 13: eine perspektivische Ansicht des Kabels mit der Hülse nach dem Konfektionierungsschritt gemäß der Figur 12,
- Figur 14: eine perspektivische Ansicht des Kabels mit abisolierten Enden der Adern,
- Figur 15: eine Detailansicht der Leiterplatte mit Bohrungen,
- Figur 16: eine perspektivische Ansicht einer elektronischen Baueinheit,
- Figur 17: eine weitere perspektivische Ansicht der elektronischen Baueinheit
- Figur 18: eine perspektivische Ansicht eines Kabels gemäß einem zweiten Ausführungsbeispiel mit der Stützschelle.

### BESCHREIBUNG DER AUSFÜHRUNGSFORMEN

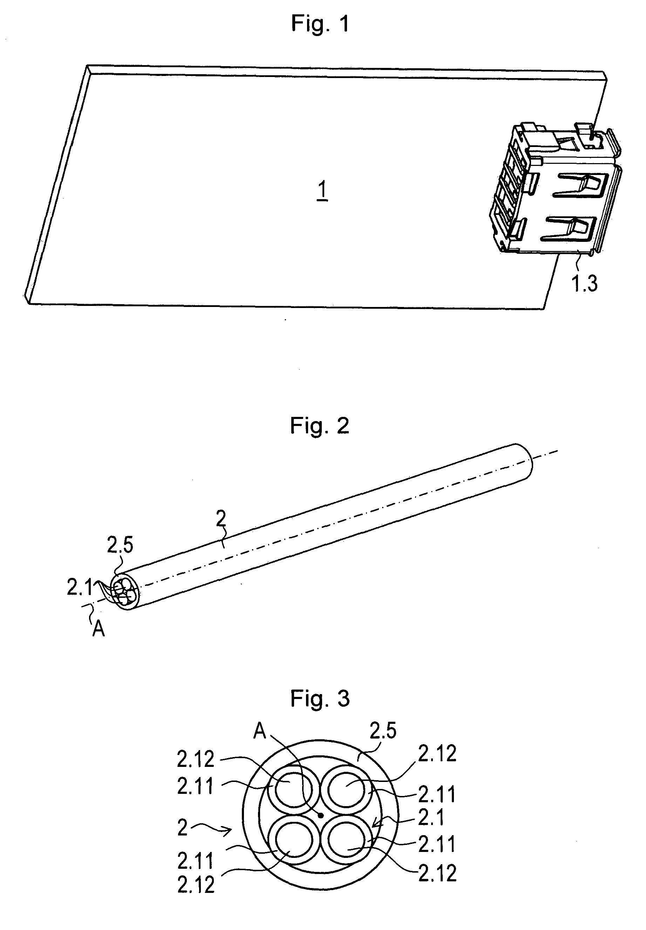

In der Figur 1 ist eine perspektivische Ansicht einer Leiterplatte 1 gezeigt, bevor die erfindungsgemäße elektronische Baueinheit zusammengebaut beziehungsweise montiert wird. Die Leiterplatte 1 umfasst unter anderem ein elektrisches Kupplungsteil 1.3.

In der Figur 2 ist ein Kabel 2 dargestellt, wie es am Beginn des Konfektionierungsprozesses vorliegt. Das Kabel ist als Rundkabel ausgestaltet und weist im vorgestellten Ausführungsbeispiel (siehe auch die vergrößerte Vorderansicht gemäß der Figur 3) vier Adern 2.1 auf, die jeweils einen innen liegenden Leiter 2.12 sowie eine Isolierung 2.11 umfassen, wobei jeder der Leiter 2.12 von einer Isolierung 2.11 umgeben ist. Die Adern 2.1, welche um eine Längsachse A herum wendelartig gedreht angeordnet sind, werden über die überwiegende Kabellänge von einem isolierenden Mantel 2.5 umschlossen. Weiterhin sind die Adern 2.1 optisch codiert, damit eine zuverlässige positionsrichtige Kontaktierung mit der Leiterplatte 1 erreicht werden kann. Zu diesem Zweck sind im vorgestellten Ausführungsbeispiel die Isolierungen 2.11 der Adern 2.1 unterschiedlich eingefärbt. Im hier beschriebenen Ausführungsbeispiel ist das Kabel 2 als ein ungeschirmtes Kabel ausgestaltet, wobei auch ein geschirmtes Kabel für die erfindungsgemäße Baugruppe zum Einsatz kommen kann, so dass dann radial außerhalb der Adern 2.1 ein Schirm beispielsweise in Form eines Schirmgeflechts vorgesehen sein kann.

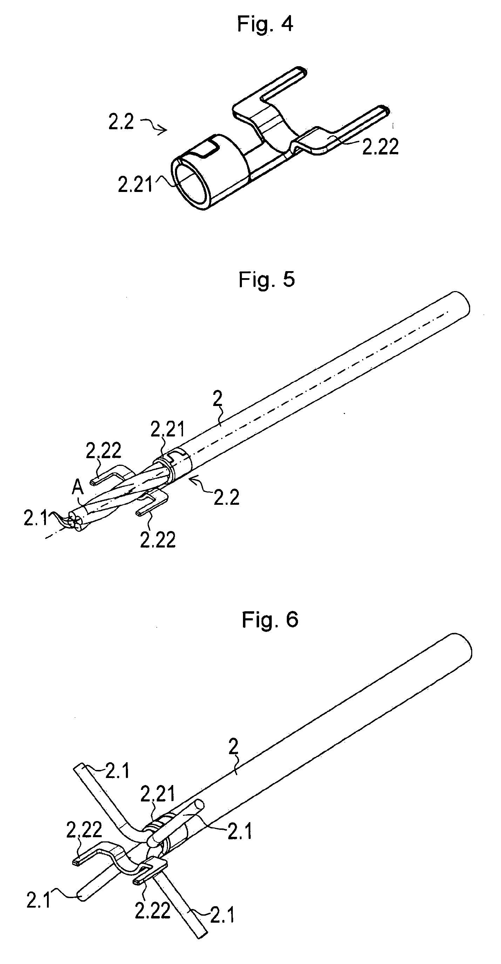

In der Figur 4 ist eine Stützschelle 2.2, die im vorgestellten Ausführungsbeispiel aus einem mit Zinn beschichteten Bronzewerkstoff hergestellt ist, vergrößert dargestellt. Demnach umfasst die Stützschelle 2.2 ein hülsenartiges Befestigungselement 2.21 und eine Gabel 2.22.

Im Zuge der Konfektionierung wird das Ende des Kabels 2 zunächst vom Mantel 2.5 befreit, so dass dort die innen liegenden Adern 2.1 freigelegt sind.

In einem darauffolgenden Konfektionierungsschritt wird das Kabel 2 in die Stützschelle 2.2, insbesondere das Befestigungselement 2.21, eingeführt bis das Befestigungselement 2.21 den Mantel 2.5 umschließt. Danach wird die Stützschelle 2.2 manuell oder automatisch relativ zu den Adern 2.1 um die Längsachse A gedreht, bis eine vorgegebene Orientierung beziehungsweise Winkelstellung der Adern 2.1 relativ zur Stützschelle 2.2 erreicht ist (beispielsweise mit Hilfe der optischen Codierung der Adern 2.1). Zur Befestigung in dieser Position wird dann die Stützschelle 2.2, insbesondere das Befestigungselement 2.21 um den Mantel 2.5 gepresst beziehungsweise gecrimpt, so dass die Stützschelle 2.2 mit dem Mantel 2.5 mechanisch fest verbunden ist. Demnach kann die Stützschelle 2.2 relativ zu den Adern 2.1 weder axial verschoben noch gedreht werden. Die Figur 5 zeigt das Kabel 2 mit der am Mantel 2.5 befestigten Stützschelle 2.2.

Nachdem die Stützschelle 2.2 relativ zu den Adern 2.1 richtig positioniert und fixiert ist, werden die Adern 2.1 radial nach außen aufgeweitet, beziehungsweise aufgebogen, so dass die Enden der Adern 2.1 entlang einer Richtung, die eine radiale Richtungskomponente aufweist orientiert sind (Figur 6).

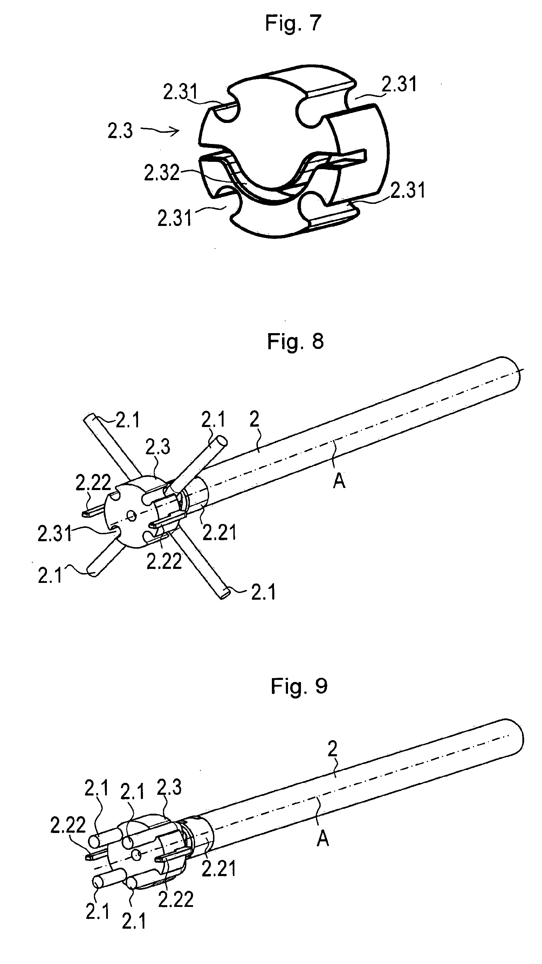

In der Figur 7 ist ein Körper 2.3 dargestellt, welcher im vorgestellten Ausführungsbeispiel aus elektrisch isolierendem Material hergestellt ist, vorzugsweise aus Kunststoff durch ein Spritzgussverfahren. Dieser Körper 2.3 weist erste Ausnehmungen 2.31 und eine zweite Ausnehmung 2.32 auf. Die ersten Ausnehmungen 2.31 weisen jeweils eine Hinterschneidung auf, so dass die jeweilige erste Ausnehmung 2.31 radial außen etwas reduziert beziehungsweise enger ist im Vergleich zu einem radial weiter innen liegenden Bereich.

In einem weiteren Schritt der Konfektionierung des Kabels 2 wird der Körper 2.3 parallel zur Längsachse A geschoben bis die Gabel 2.22 der Stützschelle 2.2 in die zweite Ausnehmung 2.32 eingeführt ist (siehe Figuren 8 und 9). Somit ist eine Verdrehsicherheit zwischen dem Körper 2.3 und der Stützschelle 2.2 und damit auch eine Verdrehsicherheit zwischen dem Körper 2.3 und den Adern 2.1 durch Formschluss hergestellt.

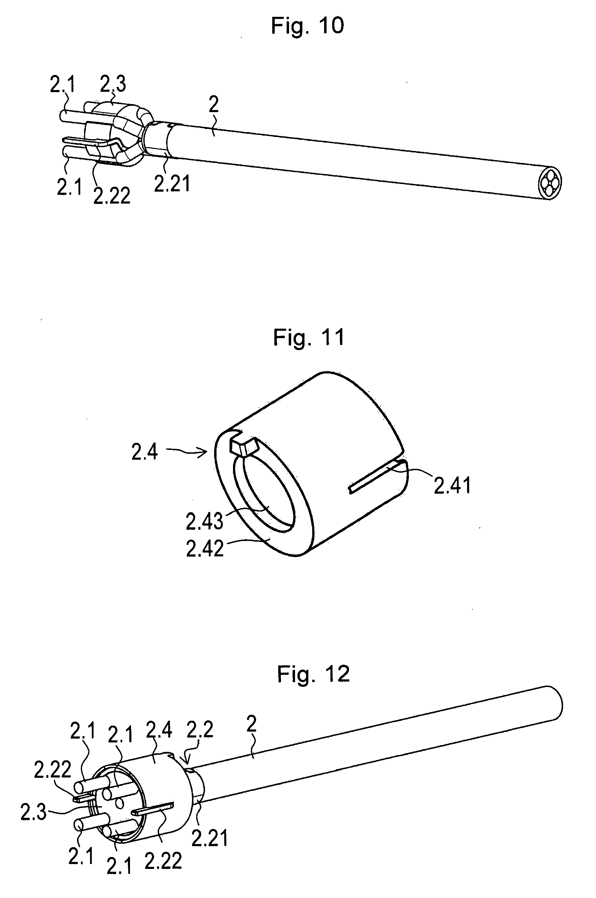

Danach werden, wie in den Figuren 9 und 10 dargestellt, die Adern 2.1 in die parallel zur Längsrichtung A verlaufenden ersten Ausnehmungen 2.31 gedrückt, wobei die Adern 2.1 durch die Hinterschneidungen der ersten Ausnehmungen 2.31 im Körper 2.3 einrasten, so dass elastische Rückstellkräfte der Adern 2.1 abgefangen werden und die Adern 2.1 jeweils parallel zur Längsrichtung A gehalten werden. Der Verlauf der Adern 2.1 wird demnach durch den Körper 2.3 so umlenkt, dass die Enden der Adern 2.1 nach einem vorgebebenen Muster positioniert sind. Die Enden der Gabel 2.22 laufen parallel zu den Enden der Adern 2.1 am Körper 2.3 vorbei.

In der Figur 11 ist eine Hülse 2.4 gezeigt, die zwei in axialer Richtung verlaufende Schlitze 2.41 aufweist, sowie einen radial nach innen ragenden Boden 2.42, welcher eine zentrale Bohrung 2.43 aufweist.

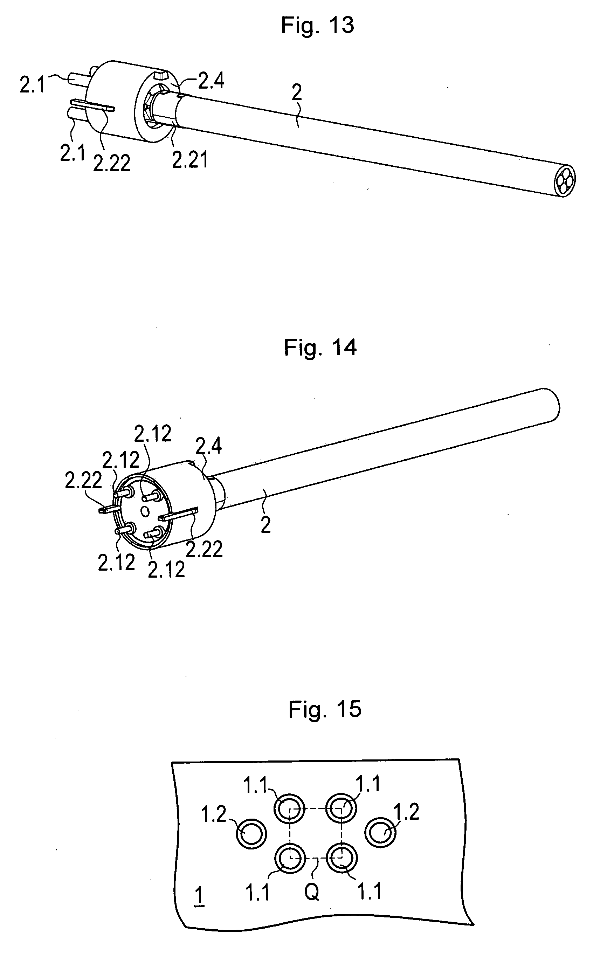

In diese Bohrung 2.43 wird das von der Stützschelle 2.2 entfernte Ende des Kabels 2 eingefädelt und die Hülse 2.4 parallel zur Längsachse A in Richtung der Stützschelle 2.2 bewegt. Die Gabel 2.22 befindet sich schließlich in den Schlitzen 2.41, wie dies beispielsweise in den Figuren 12 und 13 dargestellt ist. Somit ist die Hülse 2.4 bezüglich der Stützschelle 2.2 beziehungsweise bezüglich der Adern 2.1 verdrehsicher montiert. Durch eine geeignete Dimensionierung der Gabel 2.22 und der Hülse 2.4 beziehungsweise dessen Schlitze 2.41 wird ein Presssitz erreicht, so dass die Hülse 2.4 auch gegen axiales verrutschen relativ zur Stützschelle 2.2 gesichert ist. Alternativ oder ergänzend kann eine Umspritzung mit Kunststoff um die Stützschelle 2.2 und die Hülse 2.4 erfolgen, so dass die Umspritzung nicht nur abdichtend wirkt, sondern auch mechanische Kräfte aufnehmen kann. Durch die montierte Hülse 2.4 kann sichergestellt werden, dass die Adern 2.1 in der durch den Körper 2.3 vorgegebenen Position verbleiben und insbesondere nicht radial aus den ersten Ausnehmungen 2.31 entweichen können.

Darauffolgend werden die Adern 2.1 abisoliert, das heißt, dass an den Enden der Adern 2.1 deren Isolierungen 2.11 entfernt werden, so dass die Leiter 2.12 in diesen Bereichen freigelegt sind. Die Figur 14 zeigt das Kabel 2 nach diesem Schritt.

In einem weiteren Schritt der Herstellung der elektronischen Baueinheit werden in der Leiterplatte 1 erste Bohrungen 1.1 und zwei zweite Bohrungen 1.2 nach einem vorgegebenen Muster eingebracht, wobei sämtliche Bohrungen 1.1, 1.2 die Leiterplatte 1 durchdringen.

Die Mittelpunkte der ersten Bohrungen 1.1 spannen eine Fläche Q in Form eines Quadrats auf. Die beiden zweiten Bohrungen 1.2 liegen außerhalb der von den ersten Bohrungen 1.1 aufgespannten Fläche Q. Die ersten und zweiten Bohrungen 1.1, 1.2 werden metallisiert und Leiterbahnen werden auf der Leiterplatte 1 aufgebracht.

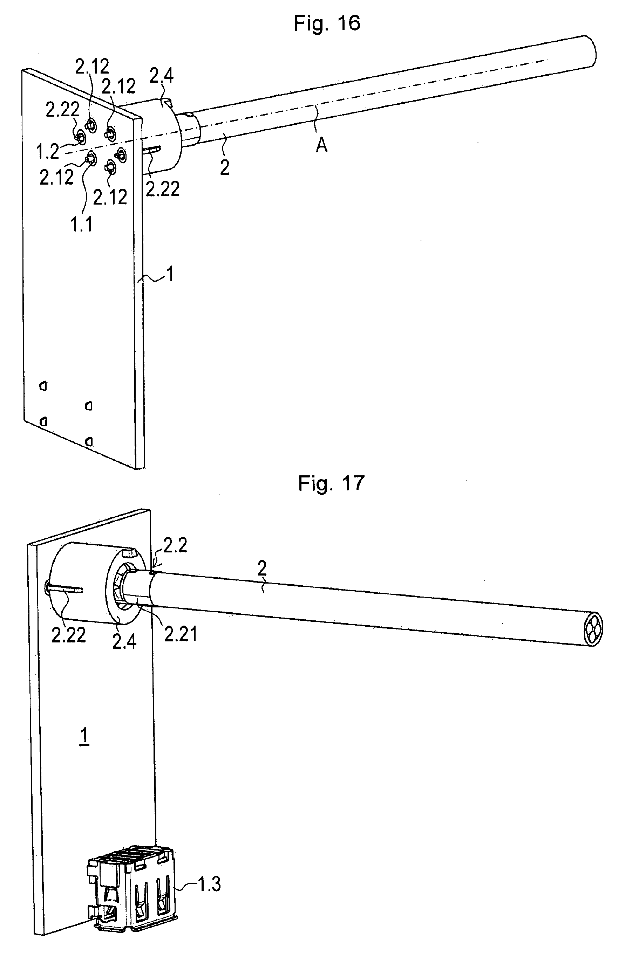

Die so vorbereitete Leiterplatte 1 wird nun mit dem Kabel 2 zusammengefügt und zwar in der Weise, dass die vier Leiter 2.12 die vier ersten Bohrungen 1.1 der Leiterplatte 1 durchdringen. Weiterhin werden in den beiden zweiten Bohrungen 1.2 die Enden der Gabel 2.22 der Stützschelle 2.2 aufgenommen. Die Längsachse A des Endes des Kabels 2 ist dabei orthogonal zur Ebene der Leiterplatte 1 orientiert. In dieser Position werden nun die Enden der Gabel 2.22 und die der Leiter 2.12 mit der Leiterplatte 1 verlötet. Dadurch entsteht eine elektronische Baueinheit wie sie in den Figuren 16 und 17 dargestellt ist mit durchkontaktierten Leitern 2.12.

Eine Übertragung von Signalen zwischen dem Kupplungsteil 1.3 und den Adern 2.1 ist nun über die Leiterbahnen der Leiterplatte 1 möglich.

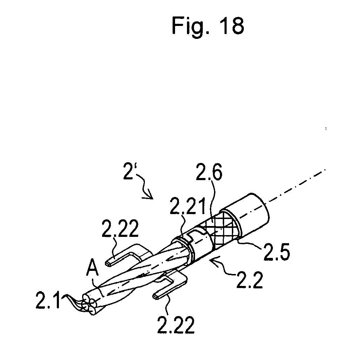

Die Figur 18 dient dazu ein zweites Ausführungsbeispiel zu erläutern. In diesem Ausführungsbeispiel wird ein geschirmtes Kabel 2' verwendet, welches sich vom Kabel 2 des ersten Ausführungsbeispiels insbesondere dadurch unterscheidet, dass zwischen dem Mantel 2.5 und den Adern 2.1 ein Schirm 2.6 angeordnet ist. In einem entsprechenden Konfektionierungsschritt wird das am Ende abgemantelte Kabel 2' in das Befestigungselement 2.21, eingeführt bis das Befestigungselement 2.21 den Schirm 2.6 umschließt. Danach wird die Stützschelle 2.2 relativ zum Schirm 2.6 um die Längsachse A gedreht, so dass eine vorgegebene Orientierung beziehungsweise Winkelstellung der Adern 2.1 relativ zur Stützschelle 2.2 erreicht ist. Zur Befestigung in dieser Position wird dann das Befestigungselement 2.21 um den Schirm 2.6 gepresst beziehungsweise gecrimpt, so dass die Stützschelle 2.2 mit dem Schirm 2.6 elektrisch kontaktiert und mechanisch fest verbunden ist.

Demnach kann die Stützschelle 2.2 relativ zu den Adern 2.1 weder axial verschoben noch gedreht werden.

Ansonsten erfolgt die Montage der elektronischen Baueinheit analog zu derjenigen des ersten Ausführungsbeispiels. Somit kann das elektrische Potenzial des Schirms 2.6 auf die Leiterplatte 1 übertragen werden. Alternativ kann im zweiten Ausführungsbeispiel die Hülse 2.4 aus Metall oder mit einer Metallschicht hergestellt sein, so dass eine optimierte Schirmung beziehungsweise EMV-Dichtigkeit an dieser Stelle erreichbar ist. Das geschirmte Kabel 2' dient etwa in Fahrzeugen zur Übertragung von HF-Signalen (Hoch-frequenz-Signalen).

## Patentansprüche

1. Elektronische Baueinheit umfassend eine Leiterplatte (1) und ein Kabel (2; 2'), wobei
die Leiterplatte (1) mindestens drei erste Bohrungen (1.1) aufweist, die nach einem vorgegebenen Muster in der Leiterplatte (1) angeordnet sind,
das Kabel (2; 2')
- mindestens drei Adern (2.1) aufweist, die um eine Längsachse (A) des Endes des Kabels herum angeordnet sind und jeweils eine Isolierung (2.11) und einen Leiter (2.12) umfassen,
- eine Stützschelle (2.2) aufweist, die ein radial außerhalb der Adern (2.1) angeordnetes Befestigungselement (2.21) aufweist, durch das die Adern (2.1) in radialer Richtung zusammengepresst und derart gehalten sind, dass die Stützschelle (2.2) relativ zu den Adern (2.1) verdrehfest fixiert ist, und
- einen Körper (2.3) aufweist, wobei der Körper (2.3) erste Ausnehmungen (2.31) aufweist und die Adern (2.1) in den ersten Ausnehmungen (2.31) angeordnet sind und eine zweite Ausnehmung (2.32) aufweist, in welcher die Stützschelle (2.2) verdrehfest aufgenommen ist, wobei
das Kabel (2; 2') so ausgestaltet ist, dass die Stützschelle (2.2) mit dem Körper (2.3) bezüglich der Längsachse (A) verdrehfest verbunden ist und durch den Körper (2.3) der Verlauf der Adern (2.1) umgelenkt ist, so dass die Enden der Adern (2.1) nach dem vorgebebenen Muster positioniert sind, wobei
an den Enden der Adern (2.1) die Isolierungen (2.11) entfernt sind, so dass die Leiter (2.12) in diesen Bereichen freigelegt sind, die Leiter (2.12) in den ersten Bohrungen (1.1) platziert sind und mit der Leiterplatte (1) elektrisch kontaktiert sind.

2. Elektronische Baueinheit gemäß dem Anspruch 1, wobei die Längsachse (A) orthogonal zur Leiterplatte (1) orientiert ist.

3. Elektronische Baueinheit gemäß einem der vorhergehenden Ansprüche, wobei der Körper (2.3) von einer radial außen liegenden Hülse (2.4) umgeben ist.

4. Elektronische Baueinheit gemäß dem Anspruch 3, wobei die Stützschelle (2.2) ein als Gabel (2.22) ausgestaltetes Ende aufweist und die Hülse (2.4) zumindest einen Schlitz (2.41) aufweist, wobei die Gabel (2.22) in den zumindest einen Schlitz (2.41) eingreift, wodurch die Hülse (2.4) verdrehfest mit der Stützschelle (2.2) verbunden ist.

5. Elektronische Baueinheit gemäß dem Anspruch 3 oder 4, wobei die Adern (2.1) von der radial außen liegenden Hülse (2.4) umgeben sind.

6. Elektronische Baueinheit gemäß einem der vorhergehenden Ansprüche, wobei die Stützschelle (2.2) mit der Leiterplatte (1) verbunden ist.

7. Elektronische Baueinheit gemäß einem der vorhergehenden Ansprüche, wobei die Stützschelle (2.2) ein als Gabel (2.22) ausgestaltetes Ende aufweist, welches in zumindest einer zweiten Bohrung (1.2) der Leiterplatte (1) platziert ist.

8. Elektronische Baueinheit gemäß dem Anspruch 7 wobei die Stützschelle (2.2) mit der Leiterplatte (1) verlötet ist.

9. Elektronische Baueinheit gemäß einem der vorhergehenden Ansprüche, wobei je einer der Leiter (2.12) in je einer der mindestens drei ersten Bohrungen (1.1) platziert ist und die Leiterplatte (1) zumindest eine zweite Bohrung (1.2) aufweist, in der ein Ende der Stützschelle (2.2) platziert ist, wobei die zumindest eine zweite Bohrung (1.2) außerhalb derjenigen Fläche liegt, welche durch die Mittelpunkte der ersten Bohrungen (1.1) aufgespannt ist.

10. Elektronische Baueinheit gemäß einem der vorhergehenden Ansprüche, wobei die Leiterplatte (1) vier erste Bohrungen (1.1) aufweist, die nach dem vorgegebenen Muster in der Leiterplatte (1) angeordnet sind, so dass die vier ersten Bohrungen (1.1) auf den Ecken eines Quadrats (Q) liegen.

11. Elektronische Baueinheit gemäß einem der vorhergehenden Ansprüche, wobei das Befestigungselement (2.21) an einem Mantel (2.5) des Kabels (2; 2') oder an einem Schirm des Kabels (2') fixiert ist.

## Claims

1. Electronic unit comprising a printed circuit board (1) and a cable (2; 2'), wherein
the printed circuit board (1) has at least three first bores (1.1) which are arranged in the printed circuit board (1) in accordance with a prespecified pattern, the cable (2; 2')
- has at least three cores (2.1) which are arranged around a longitudinal axis (A) of the end of the cable and each comprise an insulation (2.11) and a conductor (2.12),
- has a supporting clip (2.2) which has a fastening element (2.21) which is arranged radially outside the cores (2.1) and by way of which the cores (2.1) are pressed together in the radial direction and are held in such a way that the supporting clip (2.2) is fixed in a rotationally fixed manner relative to the cores (2.1) ; and
- has a body (2.3), wherein the body (2.3) has first recesses (2.31) and the cores (2.1) are arranged in the first recesses (2.31), and has a second recess (2.32) in which the supporting clip (2.2) is accommodated in a rotationally fixed manner, wherein
the cable (2; 2') is designed such that the supporting clip (2.2) is connected to the body (2.3) in a rotationally fixed manner with respect to the longitudinal axis (A) and the course of the cores (2.1) is deflected by the body (2.3), so that the ends of the cores (2.1) are positioned in accordance with the prespecified pattern, wherein
the insulations (2.11) are removed from the ends of the cores (2.1), so that the conductors (2.12) are exposed in these regions and the conductors (2.12) are placed in the first bores (1.1) and are electrically contact-connected to the printed circuit board (1).

2. Electronic unit according to Claim 1, wherein the longitudinal axis (A) is oriented orthogonally in relation to the printed circuit board (1).

3. Electronic unit according to either of the preceding claims, wherein the body (2.3) is surrounded by a radially external sleeve (2.4).

4. Electronic unit according to Claim 3, wherein the supporting clip (2.2) has an end which is designed as a fork (2.22), and the sleeve (2.4) has at least one slot (2.41), wherein the fork (2.22) engages into the at least one slot (2.41), as a result of which the sleeve (2.4) is connected to the supporting clip (2.2) in a rotationally fixed manner.

5. Electronic unit according to Claim 3 or 4, wherein the cores (2.1) are surrounded by the radially external sleeve (2.4).

6. Electronic unit according to one of the preceding claims, wherein the supporting clip (2.2) is connected to the printed circuit board (1).

7. Electronic unit according to one of the preceding claims, wherein the supporting clip (2.2) has an end which is designed as a fork (2.22) and which is placed in at least a second bore (1.2) of the printed circuit board (1).

8. Electronic unit according to Claim 7, wherein the supporting clip (2.2) is soldered to the printed circuit board (1).

9. Electronic unit according to one of the preceding clams, wherein in each case one of the conductors (2.12) is placed into in each case one of the at least three first bores (1.1), and the printed circuit board (1) has at least one second bore (1.2) in which one end of the supporting clip (2.2) is placed, wherein the at least one second bore (1.2) is situated outside that area which is spanned by the centre points of the first bores (1.1).

10. Electronic unit according to one of the preceding claims, wherein the printed circuit board (1) has four first bores (1.1) which are arranged in the printed circuit board (1) in accordance with the prespecified pattern, so that the first four bores (1.1) are situated at the corners of a square (Q).

11. Electronic unit according to one of the preceding claims, wherein the fastening element (2.21) is fixed to a jacket (2.5) of the cable (2; 2') or to a shield of the cable (2').

## Revendications

1. Module électronique comprenant une carte de circuit (1) et un câble (2; 2'),
la carte de circuit (1) présentant au moins trois premiers alésages (1.1) disposés selon un motif prédéterminé dans la carte de circuit (1),
le câble (2; 2') présentant
- au moins deux fils (2.1) disposés autour de l'axe longitudinal (A) de l'extrémité du câble et comprenant chacun un isolant (2.11) et un conducteur (2.12),
- une bride de soutien (2.2) qui présente un élément de fixation (2.21) disposé radialement à l'extérieur des fils (2.1) et par laquelle les fils (2.1) sont comprimés dans la direction radiale et maintenus de telle sorte que la bride de soutien (2.2) est immobilisée en rotation par rapport aux fils (2.1) et
- un corps (2.3), le corps (2.3) présentant des premières découpes (2.31) et les fils (2.1) étant disposés dans les premières découpes (2.31), et une deuxième découpe (2.32) dans laquelle la bride de soutien (2.2) est reprise en étant bloquée en rotation, le câble (2; 2') étant configuré de telle sorte que la bride de soutien (2.2) est raccordée au corps (2.3) sans pouvoir tourner par rapport à l'axe longitudinal (A) et que l'extension des fils (2.1) est déviée par le corps (2.3) de telle sorte que les extrémités des fils (2.1) soient disposées selon le motif prédéterminé,
les isolants (2.11) étant retirés des extrémités des fils (2.1) de telle sorte que les conducteurs (2.12) soient libérés dans ces parties, les conducteurs (2.12) étant placés dans les premiers alésages (1.1) et étant mis en contact électrique avec la carte de circuit (1).

2. Module électronique selon la revendication 1, dans lequel l'axe longitudinal (A) est orienté perpendiculairement à la carte de circuit (1).

3. Module électronique selon l'une des revendications précédentes, dans lequel le corps (2.3) est entouré par une douille (2.4) située radialement à l'extérieur.

4. Module électronique selon la revendication 3, dans lequel la bride de soutien (2.2) présente une extrémité configurée en fourche (2.22) et la douille (2.4) présente au moins une fente (2.41), la fourche (2.22) s'engageant dans la ou les fentes (2.41), grâce à quoi la douille (2.4) est reliée à rotation solidaire à la bride de soutien (2.2).

5. Module électronique selon les revendications 3 ou 4, dans lequel les fils (2.1) sont entourés par la douille (2.4) située radialement à l'extérieur.

6. Module électronique selon l'une des revendications précédentes, dans lequel la bride de soutien (2.2) est raccordée à la carte de circuit (1).

7. Module électronique selon l'une des revendications précédentes, dans lequel la bride de soutien (2.2) présente une extrémité configurée en fourche (2.22) et placée dans au moins un deuxième alésage (1.2) de la carte de circuit (1).

8. Module électronique selon la revendication 7, dans lequel la bride de soutien (2.2) est brasée sur la carte de circuit (1).

9. Module électronique selon l'une des revendications précédentes, dans lequel chaque conducteur (2.12) est placé dans l'un des trois ou plusieurs premiers alésages (1.1) et la carte de circuit (1) présente au moins un deuxième alésage (1.2) dans lequel une extrémité de la bride de soutien (2.2) est placée, le ou les deuxièmes alésages (1.2) étant situés à l'extérieur de la surface sous-tendue par les centres des premiers alésages (1.1).

10. Module électronique selon l'une des revendications précédentes, dans lequel la carte de circuit (1) présente quatre premiers alésages (1.1) disposés selon le motif prédéterminé dans la carte de circuit (1) de telle sorte que les quatre premiers alésages (1.1) soient situés sur les sommets d'un carré (Q).

11. Module électronique selon l'une des revendications précédentes, dans lequel l'élément de fixation (2.21) est fixé sur une enveloppe (2.5) du câble (2; 2') ou sur un blindage du câble (2').
